# EUROPEAN PATENT APPLICATION

(11) **EP 1 081 816 A2**
(43) Date of publication of application: **07.03.2001**
(21) Application number: 00113905.4
(22) Date of filing: 30.06.2000
(51) Int. Cl.: H01S 5/183

(54) **Vertical cavity surface emitting laser (VCSEL) having undoped distributed bragg reflectors and using lateral current injection and method for maximizing gain and minimizing optical cavity loss**

(30) Priority: 03.09.1999 US 389919
(71) Applicant: Agilent Technologies Inc, Palo Alto, CA 94306-2024 (US)
(72) Inventor: Corzine, Scott W., Sunnyvale, California 94087 (US); Babic, Dubravko I., Palo Alto, California 94306 (US); Tan, Michael R. T., Menlo Park, California 94025 (US)
(74) Representative: Liesegang, Eva

(57) **Abstract**

A vertical cavity surface emitting laser (VCSEL 10) including two undoped distributed Bragg reflectors (DBRs 16,18) and an undoped active region (14) therebetween, and employing lateral current injection to the undoped active region (14) minimizes optical loss within the laser. A periodic gain structure may also be employed in the VCSEL (10), thus maximizing gain in the undoped active region (14). The undoped distributed Bragg reflectors (DBRs) in the VCSEL, reduce the optical loss within the cavity.

## Description

### TECHNICAL FIELD

The invention relates generally to semiconductor light emitting devices, and, more particularly, to a vertical cavity surface emitting laser having undoped distributed Bragg reflectors (DBRs) and using lateral current injection and a method for maximizing gain and minimizing optical cavity loss.

### BACKGROUND OF THE INVENTION

Semiconductor lasers in general, and vertical cavity surface emitting lasers (VCSELs) in particular have been used for quite some time in fields such as optical communications.

The structure of a typical VCSEL cavity includes an active region that is sandwiched between a pair of distributed Bragg reflectors (DBRs). The active region is the area in which electrons and holes recombine to produce useful laser light. The active region may be constructed of bulk semiconductor material, or may be constructed using multiple quantum wells (MQWs) as known in the art. The DBRs are conductive, therefore, current flows through the DBRs into the active region, where recombination of electrons and holes takes place in the active region, thus producing useful light. In this VCSEL arrangement, one of the DBRs will be slightly less reflective than the other to allow light to exit the device through the less reflective DBR.

One of the drawbacks of this arrangement is that the DBRs must be doped so that current may pass through them. Doping is the process by which the semiconductor material is made conductive by adding either p-type or n-type impurities (or dopants) to the material. However, doping increases the absorption of light within the DBR due to free carrier absorption in both p and n-type materials. In addition, for p-type material, intervalence band absorption further increases the absorption of light within the DBR. These conditions reduce the amount of light available for output from the device. The efficiency of the laser is dependent upon the output coupling, or the amount of light output, versus the amount of light lost within the laser. Increasing the gain and reducing the internal losses within the laser cavity increases the efficiency of the laser.

Thus, an unaddressed need exists in the industry for a way of increasing the gain in a laser cavity, while minimizing the material loss within the laser cavity, to improve the efficiency and overall operation of the laser.

### SUMMARY OF THE INVENTION

The invention provides a highly efficient VCSEL having low optical loss within the laser cavity. Although not limited to these particular applications, the concepts of the invention are particularly applicable to long wavelength VCSELs.

In a vertical cavity surface emitting laser (VCSEL) including two distributed Bragg reflectors (DBRs) and an undoped active region therebetween, the VCSEL also including p-type and n-type material adjacent to the undoped active region, the invention can be conceptualized as a method for minimizing optical cavity loss, the method comprising the steps of: forming the DBRs such that they are undoped; and laterally injecting current into the undoped active region.

In architecture, the invention may be conceptualized as a vertical cavity surface emitting laser (VCSEL), comprising: two undoped distributed Bragg reflectors (DBRs) and an undoped active region therebetween. The VCSEL also includes p-type and n-type material laterally adjacent to the undoped active region, wherein the undoped active region and the p-type and the n-type material adjacent the undoped active region are configured for lateral current injection.

The invention has numerous advantages, a few which are delineated below merely as examples.

An advantage of the invention is that it increases the efficiency of a VCSEL.

Another advantage of the invention is that it allows the implementation of a VCSEL having an undoped active region and undoped DBRs.

Another advantage of the invention is that it allows a VCSEL to be constructed using undoped DBRs.

Another advantage of the invention is that it allows the implementation of a periodic gain structure within a VCSEL.

Another advantage of the invention is that the periodic gain structure allows for an increased number of MQWs resulting in the distribution of heat and stimulated emission over a larger active volume, which reduces the temperature within the laser and reduces thermal effects that limit the power of VCSELs.

Another advantage of the invention is that increasing the quantity of MQWs in the active region allows the gain of the VCSEL to be increased, which allows the required reflectivity of the DBRs to be lowered. This arrangement relaxes the design constraints of the DBRs, while increasing the optical efficiency of the laser.

Another advantage of the invention is that a VCSEL according to the invention is simple in design and easily implemented on a mass scale for commercial production.

Other features and advantages of the invention will become apparent to one with skill in the art upon examination of the following drawings and detailed description. These additional features and advantages are intended to be included herein within the scope of the invention.

### BRIEF DESCRIPTION OF THE DRAWINGS

The invention, as defined in the claims, can be better understood with reference to the following drawings. The components within the drawings are not necessarily to scale relative to each other, emphasis instead being placed upon clearly illustrating the principles of the invention.
Fig. 1A is a cross-sectional schematic view illustrating a vertical cavity surface emitting laser (VCSEL) constructed in accordance with the invention;
Fig. 1B is a cross-sectional schematic view illustrating an alternative embodiment of the VCSEL of Fig. 1A including a periodic gain structure in the active region;
Fig. 1C is a graphic representation of the standing wave pattern and the multiple quantum wells 28a-28b of Fig. 1B;
Fig. 2A is a graphical representation of a conventional vertical injection VCSEL including a periodic gain structure;
Fig. 2B is a graphical representation of the periodic gain structure as applied to the VCSEL constructed in accordance with the invention;
Fig. 3A is a cross-sectional schematic view of VCSEL 10 of Figs. 1A-1C illustrating the lateral current injection scheme of the invention;
Fig. 3B is a graphical representation of a vertical band diagram illustrating the effects on current confinement provided by the disordered region of Fig. 3A;
Fig. 3C is a lateral band profile of the undoped active region 14 of Fig. 3A; and
Fig. 4 is a vertical band diagram comparing the electron barrier height Ø_{B} obtained by disordering a low bandgap cladding material versus disordering a high bandgap cladding material.

### DETAILED DESCRIPTION OF THE PREFERRED EMBODIMENT

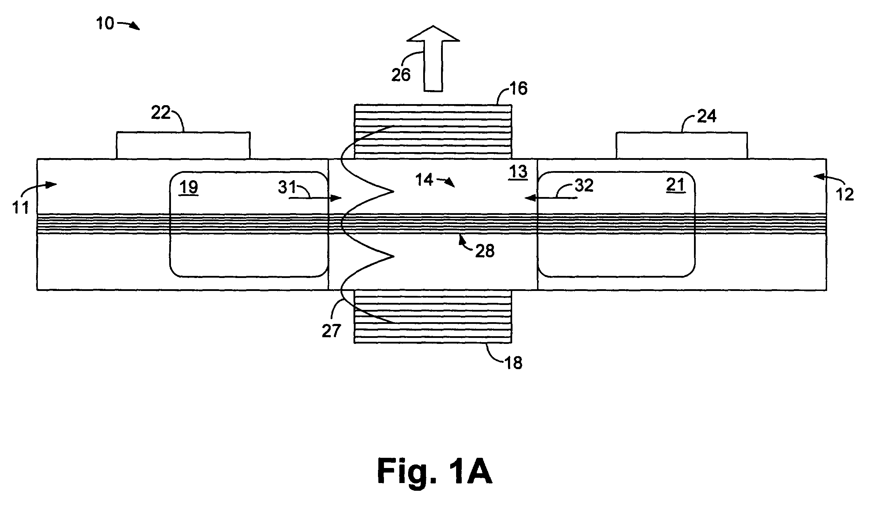

Turning now to the drawings, Fig. 1A is a cross-sectional schematic view illustrating a vertical cavity surface emitting laser (VCSEL) constructed in accordance with the invention. VCSEL 10 includes n-type material region 11 and p-type material region 12 surrounding intrinsic material region 13. The intrinsic material region 13 includes undoped semiconductor material and is also the material in which the active region 14 of the VCSEL is created. As known in the art, VCSEL 10 is typically constructed by growing layers of semiconductor material over a substrate, such as indium phosphide (InP) or gallium arsenide (GaAs) (not shown), and typically includes a number of material layers. The material layers that comprise VCSEL 10 include all n-type material region 11, intrinsic region 13 and p-type material region 12. The type of doping determines the different regions. For example, n-type material region 11 may be doped via ion implantation or diffusion or other techniques known in the art, resulting in an n-type material. Similarly, p-type material region 12 can be doped in similar fashion, resulting in p-type material.

In accordance with the invention, intrinsic region 13 remains undoped by masking, or other techniques, to prevent the intrinsic region 13 from having either p or n-type characteristics.

Deposited on intrinsic region 13 are DBRs 16 and 18. DBRs 16 and 18 are typically constructed using alternating layers of semiconductor material having different refractive indices and are undoped in accordance with the invention. For example, the difference in the refractive indices of the materials comprising the layer pair determines the reflectivity of the layer pair. The thickness of each is λ/4n (or odd multiples thereof), where λ is the in vacuum wavelength of light reflected and n is the refractive index of the material. Note that any odd integer multiple of λ/4n may be used. For example, material thickness of 3λ/4n or 5λ/4n may be used as well. As used herein, the term cavity includes undoped DBRs 16 and 18 and undoped active region 14.

DBRs 16 and 18 are constructed so that one of the DBRs, in this case DBR 16, is slightly less reflective than DBR 18, resulting in the light output indicated in the direction of arrow 26. Alternatively, DBR 18 may be constructed to be less reflective than DBR 16, in which case the light output would be in the direction opposite that indicated by arrow 26.

In accordance with an aspect of the invention, DBRs 16 and 18 are also constructed of undoped semiconductor material. Alternatively, there may be some instances where DBRs 16 and 18 could be unintentionally lightly doped because of an effect known as background doping. Background doping occurs when material adjoining the DBRs is doped, and due to the inability to precisely control the doping operation, the DBRs unintentionally become lightly doped. In such instances the lightly doped DBRs still provide significantly less optical cavity loss than conventionally doped DBRs.

VCSEL 10 includes metal contacts 22 and 24 connected to n-type material region 11 and p-type material region 12, respectively, through which an electrical potential applied to VCSEL 10 causes the movement of electrons and holes into undoped active region 14.

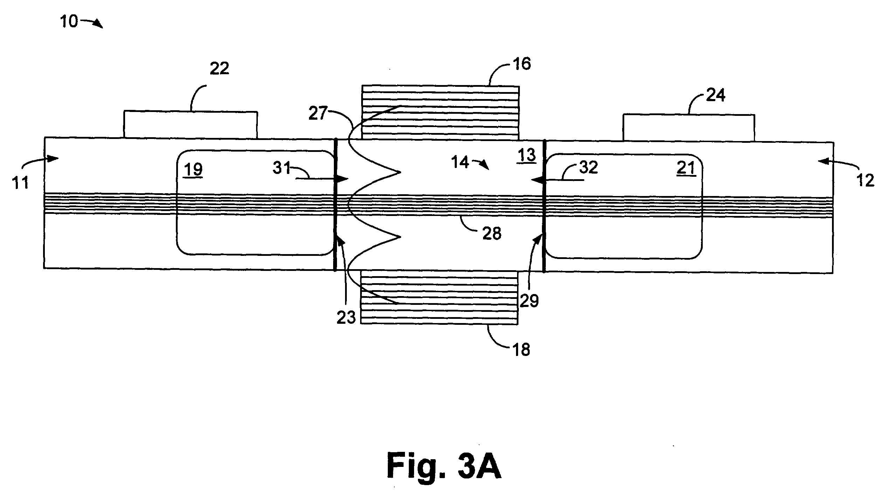

In accordance with another aspect of the invention, and to improve current confinement within the VCSEL, which will be described with reference to Figs. 3A-3C, a portion of n-type material region 11 and a portion of p-type material region 12 may be disordered in the vicinity of each material regions' interface with intrinsic material region 13. Disordering is a process by which the structure of the material layers comprising the n and p-type regions is altered such that a large difference in bandgap appears where the n-type material region 11 meets the intrinsic material region 13, and where the p-type material region 12 meets the intrinsic material region 13. The concept of disordering, and its applicability to the invention, will be described in detail below.

VCSEL 10 further includes undoped active region 14 within intrinsic material region 13. Undoped active region 14 is the region in which electrons and holes recombine to produce the light output of the VCSEL 10. Electrons travel in the direction indicated by arrow 31 from n-type material 11 and holes travel in the direction indicated by arrow 32 from p-type region 12, to recombine within undoped active region 14.

Undoped active region 14 may include a bulk semiconductor material or may include a multiple quantum well (MQW) structure. Examples of a bulk semiconductor include gallium arsenide, indium gallium arsenide, and induim gallium arsenide phosphide.

In a preferred embodiment, active region 14 includes multiple quantum wells (MQWs) 28. MQWs 28 are located at a peak of the standing wave pattern 27. Standing wave pattern 27 is a graphical representation of the electric field that is created within undoped active region 14 between undoped DBR 16 and undoped DBR 18. As illustrated, a peak of standing wave pattern 27 typically occurs at the interface of each DBR and undoped active region 14. Furthermore, multiple quantum wells are located at another peak of standing wave pattern 27 to capitalize on the high electric field, at the peak.

The VCSEL structure 10 shown in Fig. 1A illustrates a configuration which allows lateral current injection, *i.e.,* a current flow direction perpendicular to the direction in which light is emitted, and parallel to the layers of semi-conductor material. Lateral current injection results from the movement of electrons and holes laterally from n-type material 11 and p-type material 12, respectively, into undoped active region 14. Lateral current injection allows the use of undoped DBRs and an undoped active region, thus minimizing internal losses within the lasing cavity. Lateral current injection eliminates the requirement of having doped DBRs because the lateral injection scheme allows electrons and holes to enter the active region without passing through the DBRs.

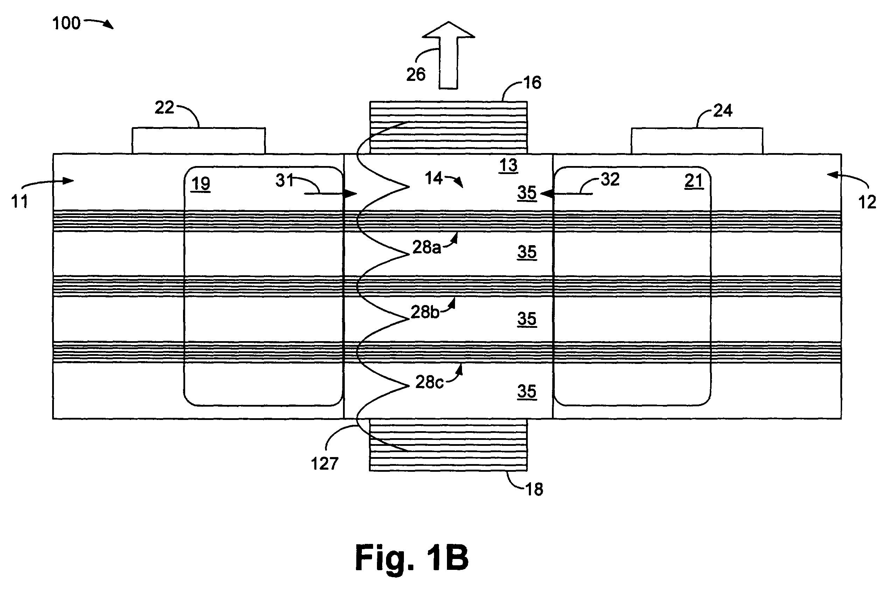

Fig. 1B is a cross-sectional schematic view illustrating an alternative embodiment of the VCSEL 10 of Fig. 1A. The alternative embodiment has a periodic gain structure in the active region. Like numbered elements with respect to Fig. 1A will not be described again in detail.

VCSEL 100 includes undoped active region 14 with multiple quantum wells 28a-28c configured in a periodic gain structure. In the example shown, the standing wave pattern 127 that occurs in VCSEL 100 has five peaks. The peaks in the standing wave occur due to reflections from the DBRs. The number of peaks is determined by the thickness of the active region. As illustrated with respect to Fig. 1A, a peak occurs at the intersection of undoped active region 14 and DBR 16 and at the intersection of undoped active region 14 and DBR 18. However, now there are three peaks in standing wave pattern 127 between DBR 16 and DBR 18. At each one of these standing wave peaks, a layer of multiple quantum wells is located. For example, multiple quantum wells 28a, 28b and 28c each occur at one of the peaks of standing wave pattern 127 between DBR 16 and DBR 18. This arrangement is referred to as a periodic gain structure, and greatly improves the gain of undoped active region 14. It should be mentioned that a greater or fewer number of standing wave peaks and associated multiple quantum wells may be constructed.

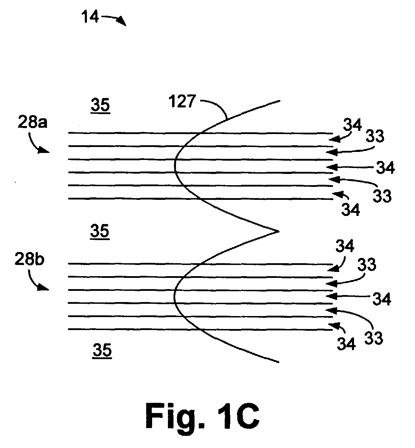

Fig. 1C is a graphic representation of part of the standing wave pattern 127 and the multiple quantum wells 28a and28b of Fig. 1B. Each multiple quantum well 28a and 28b occurs at a peak of standing wave pattern 127. Each multiple quantum well 28 includes, for example, a plurality of 80 Ångstrom (Å) quantum wells 34 alternating with a plurality of 80 Å high bandgap material cladding layers 33. Each multiple quantum well 28 may be comprised of, for example, five 80 Å quantum well layers 34 alternating with six 80 Å high bandgap cladding layers 33. The region between the standing wave pattern peaks is comprised of a thicker (on the order of one thousand Å) layer 35 of high bandgap material cladding layer.

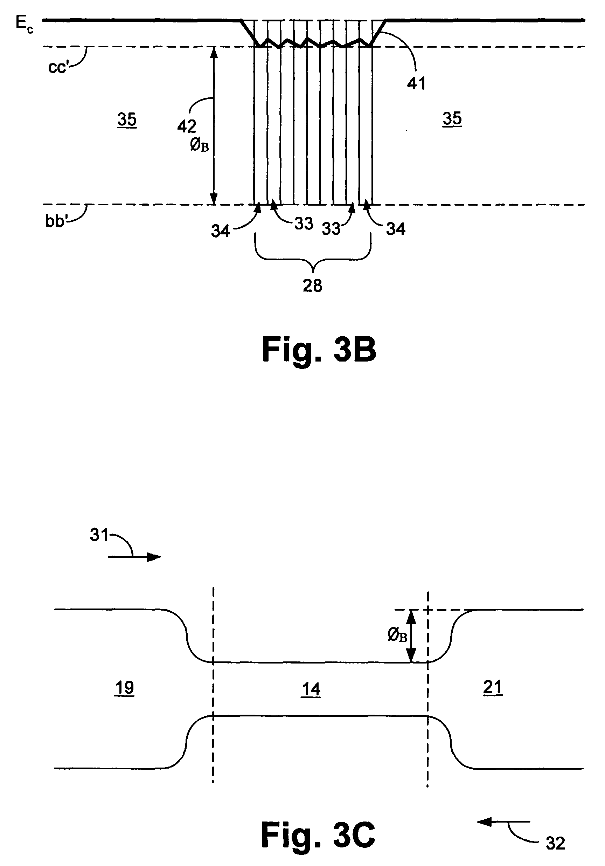

The structure shown in VCSELs 10 and 100, in which an undoped active region 14 includes multiple quantum wells 28, has a very high degree of current confinement relative to what can be obtained in, for example, an edge emitting laser. This high degree of current confinement is possible because of the manner in which adjacent quantum well layers 34 are separated by a high bandgap cladding layer 33 and will be described in greater detail with respect to Figs. 3B-3C.

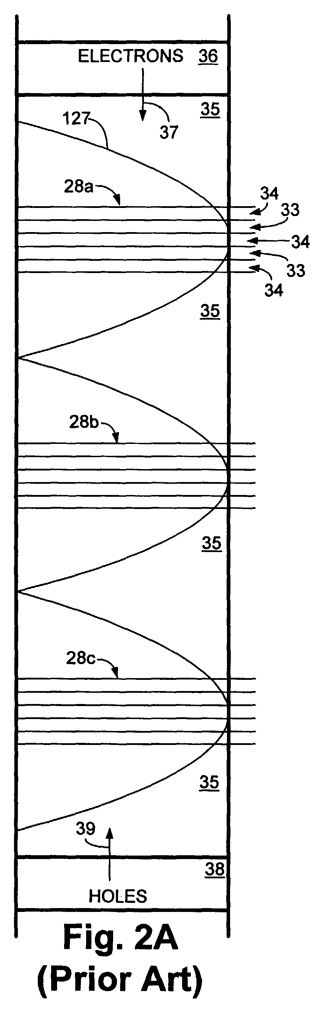

Fig. 2A is a graphical representation of a conventional vertical injection VCSEL including a periodic gain structure. The peaks in standing wave pattern 127 illustrate the regions in which a maximum electric field is present. Therefore, in order to capitalize on this high electric field, the concept of periodic gain places quantum wells at each peak in standing wave pattern 127, and leaves the regions between the peaks, where the electric field is less than at the peaks, devoid of quantum wells. As illustrated, multiple quantum well 28a resides at or near the first peak of standing wave pattern 127 to occur after DBR 36. While multiple quantum will 28a will be discussed, the same discussion applies for multiple quantum wells 28b and 28c of Fig. 1B. Multiple quantum wells 28a include, for example, a plurality of 80 Å wide quantum wells 34 separated by a plurality of 80 Å wide layers of high bandgap material cladding 33. This structure is repeated in the vicinity of each peak of standing wave pattern 127.

To help illustrate the operation of a periodic gain structure in a lateral current injection VCSEL constructed in accordance with the invention, the operation of a periodic gain structure as shown in Fig. 2A in a conventional-vertical injection VCSEL structure, will be described first.

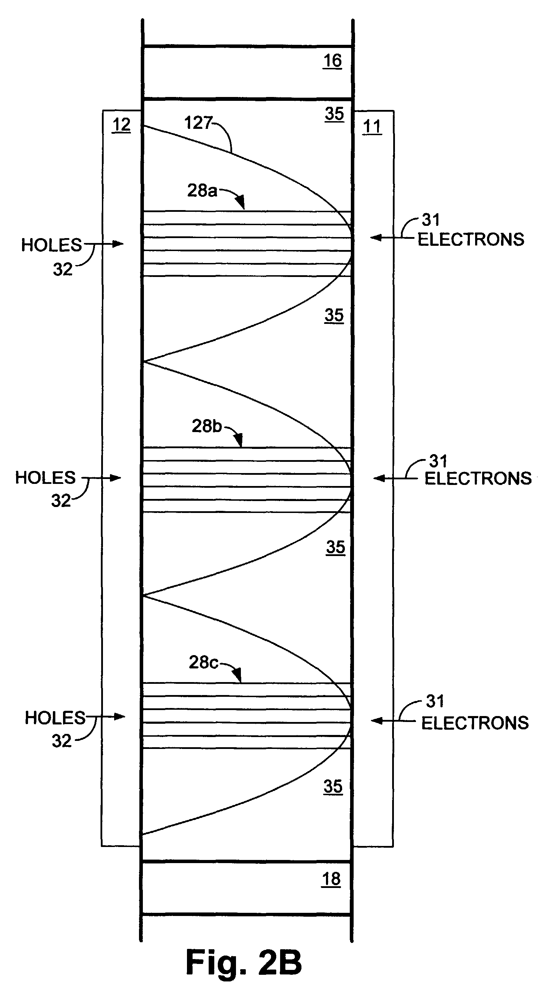

As shown in Fig. 2A, the electrons traveling perpendicular to the plane of the quantum wells layers, *i.e.,* in the direction indicated by arrow 37, travel through doped DBR 36 and, because of their high mobility have little difficulty in traveling to the peaks of standing wave pattern 127. Conversely, holes traveling in the direction indicated by arrow 39 travel through DBR 38, but are much less mobile than electrons. Holes have little difficulty entering the multiple quantum well structure 28c, but because of their lower mobility, holes have difficulty traveling to multiple quantum wells 28b and 28a. As will be described with respect to Fig. 2B, lateral current injection eliminates the drawback of requiring electrons and holes to traverse the multiple quantum wells, one group after the next, by allowing electrons and holes unimpeded access to the active region.

Fig. 2B is a graphical representation of the periodic gain structure as applied to the lateral current injection VCSEL constructed in accordance with the invention.

The elements in Fig. 2B that are the same as those discussed with respect to Fig. 2A are like numbered and will not be discussed again in detail.

In a VCSEL constructed in accordance with the invention, the n-type material region 11 and p-type material region 12 surround the undoped active region 14 in such a way as to enable holes to travel in the direction indicated by arrow 32, and electrons to travel in the direction indicated by arrow 31 equally into all multiple quantum wells 28a, 28b and 28c. As illustrated in Fig. 2B, and in comparison to that described with respect to Fig. 2A, the electrons and holes traveling in the direction indicated by arrows 31 and 32, respectively, no longer need to pass through the thickness of the cladding layer 35 between the multiple quantum wells 28c and 28b, and 28c to 28a. As shown in Fig. 2B, the holes traveling along path 32 can be easily injected from p-type material region 12 into the multiple quantum wells 28a, 28b and 28c in parallel. Similarly, the electrons traveling along path 31 can be easily injected from n-type material region 11 into the multiple quantum wells 28a, 28b and 28c in parallel.

Fig. 3A is a cross-sectional schematic view of VCSEL 10 of Figs. 1A-1C illustrating the lateral current injection scheme and the material disordering of the invention. As mentioned above, disordering the n-type and p-type material regions 11 and 12, respectively, to form n-type disordered region 19 and p-type disordered region 21, respectively, adjoining undoped active region 14 improves current confinement in the undoped active region in which a high bandgap material cladding layer 33 is alternately applied with the low bandgap quantum wells layer 34. Stated differently, the disordered regions 19 and 21 present a high barrier to electron leakage, particularly at the interface 29 between undoped active region 14 and the disordered p-type material region 21. The effect of disordering will be explained in further detail with respect to Fig. 3B.

The VCSEL structure in accordance with the invention also reduces another type of current leakage that occurs when current flows through the layers 35 of high bandgap material cladding layers separating multiple quantum wells 28a, 28b and 28c. The structure of a VCSEL in accordance with the invention, which includes high bandgap material cladding layers separating the multiple quantum wells, forces a majority of the current to flow through the low bandgap quantum well material while minimizing the amount of current that flows through the high bandgap barrier cladding layers 35.

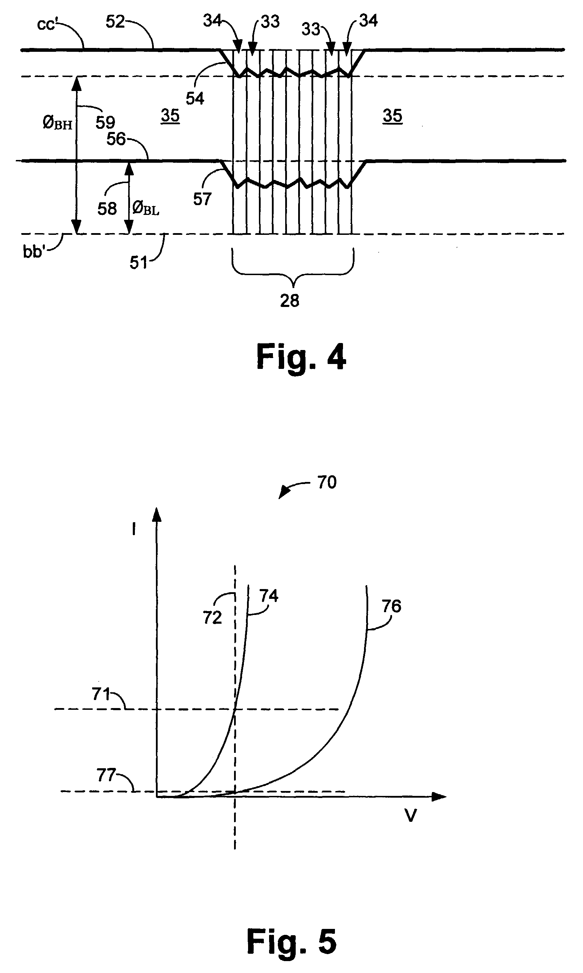

Current confinement using layers of different band-gap materials has previously been used in edge-emitting lasers. However, in edge-emitting lasers, the same structure is used to provide both optical confinement and current confinement. This requires that the confinement structure be formed of a low band-gap material and an intermediate band-gap material, which compromises the effectiveness of the current confinement. In the VCSEL structure according to the invention, the current confinement structure is not also required to provide optical confinement, and so can be formed of low band-gap material multiple quantum wells and high band-gap energy cladding layers. This greatly increases the effectiveness of the current confinement compared with the current confinement obtained in edge-emitting lasers. This arrangement results in a lower leakage current than would be possible in an edge-emitting structure in which an intermediate bandgap material cladding layer is necessary to obtain the desired optical mode confinement. The intermediate bandgap cladding material that is required in an edge-emitting laser prevents a high bandgap cladding layer from being applied adjacent to the low bandgap quantum well, thus preventing an edge-emitting laser from achieving the level of current confinement achievable by a VCSEL constructed in accordance with the invention. In this manner, a VCSEL constructed in accordance with the invention has significant advantages over an edge-emitting laser. This current confinement will be described in greater detail with reference to Fig. 5.

Fig. 3B is a graphical representation of a vertical band diagram illustrating the effects on current confinement provided by disordered region 21. Line bb' represents the minimum energy level in the VCSEL 10 of Fig. 3A, which energy level occurs in undoped active region 14 in the vicinity of each quantum well 34. Line cc' represents the energy level present in the VCSEL after disordering the p-type material region 12 and the n-type material region 11.

Upon disordering part of p-type material region 12, the material at the interface 29 of p-type material 12 and undoped active region 14 presents a barrier to current flow. The energy level encountered by an electron reaching the interface is drastically altered as illustrated by disordered region line 41. Disordered region line 41 illustrates an approximation of the drastic change in energy level evident in disordered region 21 after disordering. Before disordering, the energy level across the entire multiple quantum well structure 28 is the same irrespective of whether the multiple quantum well 28 resides in p-type material region 12, undoped active region 14, or n-type material region 11. On other words, there is nothing to prevent current from flowing in the multiple quantum well 28 through the interface 23 between n-type material region 11 and undoped active region 14, and through the interface 29 between p-type material region 12 and undoped active region 14. After disordering, the energy differential at the interface between disordered region 21 and undoped active region 14 (and the interface 23 between disordered region 19 and undoped active region 14) is represented by the term Ø_{B} indicated by line 42. This energy barrier Ø_{B} represents the change in energy due to disordering, and effectively indicates that multiple quantum wells 28 no longer exist at the interface of disordered region 21 and undoped active region 14. In this manner, disordering the p-type material region 12 drastically improves lateral current confinement of the VCSEL structure 10 by creating a barrier to electron flow at that interface. An analogous condition is created at the interface between n-type disordered region 11 and undoped active region 14.

As stated above, the structure of VCSELs in general allows a high bandgap cladding layer to be alternately applied with each quantum well in the multiple quantum well structure, without the use of a intermediate bandgap layer as required in edge-emitting lasers. This structure enables VCSELs to employ the above described disordering in order to maximize lateral current confinement. This concept will be further illustrated below with respect to Fig. 4.

Fig. 3C is a lateral band profile of the undoped active region 14 of Fig. 3A illustrating the manner in which disordering creates a double heterostructure. The double heterostructure laterally confines electrons and holes within the undoped active region 14.

As referred to in Fig. 3B, disordering the p-type material region 12 to form disordered region 21 and disordering n-type material 11 to form disordered region 19 adjacent to undoped active region 14, creates an electron and hole barrier height Ø_{B} at interface 23 and interface 29 of Fig. 3A. This disordering effectively forms the double heterostructure illustrated in Fig. 3C. To further illustrate the improvement in current confinement made possible using a lateral current injection VCSEL constructed in accordance with the invention, over that possible using an edge-emitting laser, Fig. 4B shows a vertical band diagram comparing the electron barrier height Ø_{B} obtained by disordering a low bandgap cladding material versus disordering a high bandgap cladding material. The electron and hole barrier height Ø_{B} is significantly higher in a lateral current injection VCSEL than would be possible using an edge-emitting laser structure because of the intermediate bandgap cladding material required in an edge-emitting laser. The intermediate bandgap cladding material is required in an edge-emitting laser to form an optical waveguide to confine the optical mode of the laser.

As illustrated in Fig. 4, the electron barrier height Ø_{B} can be maximized more easily in a VCSEL than in an edge emitting laser by using high bandgap cladding layers alternately applied with quantum well layers as described above. Line bb*'* 51 is illustrative of the low energy level in undoped active region 14 through the presence of multiple quantum wells 28. Assuming a low bandgap cladding material, or possibly an intermediate bandgap cladding material as typically used in edge emitting lasers, the electron barrier height Ø_{B} obtained by disordering the low or intermediate bandgap cladding is illustrated by the electron barrier height Ø_{BL} shown with reference to line 58. When a low or intermediate bandgap cladding material having an energy depicted by line 56 is disordered, resulting in the energy represented by line 57, the electron barrier height Ø_{B} is lower than when disordering a high bandgap cladding layer. To illustrate, section line cc*'* 52 represents the highest energy level obtained in the system of Fig. 4 prior to disordering. When a high bandgap cladding material is disordered, as illustrated by line 54, the electron barrier height Ø_{BH} as illustrated by line 59 is greater than the electron barrier height Ø_{BL} obtained when a low or intermediate bandgap cladding material is disordered. As shown, the value of electron barrier height Ø_{BH} shown with respect to line 59 is significantly greater than the value of electron barrier height Ø_{BL} shown by line 58.

Because a VCSEL structure allows high bandgap cladding layers 33 to be alternated with quantum wells 34, electron barrier height Ø_{BH} can be maximized in VCSELs more easily than in edge emitting lasers, where an intermediate bandgap material must be used in order to create a waveguide to contain the optical mode.

Fig. 5 is a graphical illustration of the current-voltage curves of the high bandgap cladding material and the low bandgap quantum well material of a VCSEL using lateral current injection in accordance with the invention. Referring back to Fig. 1C, the active region of the VCSEL is comprised of low bandgap quantum wells 34 alternating with high bandgap cladding material 33. Referring now to Fig. 5, the voltage across a VCSEL incorporating each of these materials is plotted along the horizontal axis, while the current flowing through each of the materials is plotted along the vertical axis. The curve 74 illustrates the current-voltage characteristics of low bandgap multiple quantum well 34 and curve 76 represents the current-voltage characteristics of high bandgap cladding material 33. As illustrated, at the bias voltage illustrated by line 72, there is significantly more current, as represented by line 71, flowing through the low bandgap quantum well material than there is current, represented by line 77 flowing through the high bandgap cladding material.

The current represented by line 77 represents the leakage current through the cladding material. The turn-on voltage of the high bandgap cladding material is significantly higher than the turn-on voltage of the low bandgap quantum well material, thus enabling a VCSEL constructed in accordance with the invention to permit a low level of leakage current. The lateral current injection VCSEL structure permits a high bandgap cladding material to be located adjacent to the low bandgap quantum well material, thus providing superior current confinement over that achieved by implementing a lateral current injection scheme with an edge-emitting laser. A lateral current injection scheme in an edge-emitting laser must use an intermediate bandgap cladding material adjacent to the low bandgap quantum well and has a lower turn-on voltage and higher leakage current.

It will be apparent to those skilled in the art that many modifications and variations may be made to the preferred embodiments of the invention, as set forth above, without departing substantially from the principles of the invention. For example, the VCSEL described can be used in a variety of applications using both undoped and lightly doped DBRs. All such modifications and variations are intended to be included herein within the scope of the invention, as defined in the claims that follow.

## Claims

1. In a vertical cavity surface emitting laser (VCSEL) (10) including two distributed Bragg reflectors (DBRs) (16, 18) and an undoped active region (14) therebetween, said VCSEL (10) also including p-type (12) and n-type (11) material adjacent to said undoped active region (14), a method for minimizing optical cavity loss, the method comprising the steps of:
forming said DBRs (16, 18) such that they are undoped; and
laterally injecting current (31, 32) into said undoped active region (14).

2. The method of claim 1, further comprising the step of disordering (19, 21) said p-type (12) and n-type (11) material adjacent to said undoped active region (14).

3. The method of claim 1 or 2, wherein said undoped active region (14) includes bulk semiconductor material.

4. The method of one of the preceding claims, further comprising the step of disposing a quantum well (34) between two layers of high bandgap cladding material (33) in said undoped active region (14).

5. The method of claim 4, further comprising the step of disposing a plurality of high bandgap cladding layers (33) alternating between a plurality of quantum wells (34).

6. The method of claim 5, wherein said undoped active region (14) exhibits periodic gain.

7. The method of one of the preceding claims, wherein each of said two DBRs (16, 18) are lightly undoped.

8. A vertical cavity surface emitting laser (VCSEL) (10), comprising:
two undoped distributed Bragg reflectors (DBRs) (16, 18) and an undoped active region (14) therebetween, said VCSEL (10) also including p-type (12) and n-type (11) material laterally adjacent to said undoped active region (14);
wherein said undoped active region (14) and said p-type (12) and said n-type (11) material adjacent said undoped active region (14) are configured for lateral current injection.

9. The VCSEL (10) of claim 8, further comprising a disordered p-type material (21) and a disordered n-type material (19) adjoining said undoped active region (14).

10. The VCSEL (10) of claim 8 or 9, wherein said undoped active region (14) further comprises a quantum well (34) disposed between two layers of high bandgap cladding material (33).
